# EUROPÄISCHE PATENTANMELDUNG

(11) **EP 3 786 311 A1**
(43) Veröffentlichungstag der Anmeldung: **03.03.2021**
(21) Anmeldenummer: 19194710.0
(22) Anmeldetag: 30.08.2019
(51) Int. Cl.: C23C 14/16, C23C 14/24, C23C 14/26, C23C 14/56, H01B 12/00, H01L 39/24

(54) **VORRICHTUNG, VERFAHREN UND SYSTEM ZUR BESCHICHTUNG EINES SUBSTRATS, INSBESONDERE EINES SUPRALEITENDEN BANDLEITER SOWIE BESCHICHTETER SUPRALEITENDER BANDLEITER**

(71) Anmelder: Theva Dünnschichttechnik GmbH, 85737 Ismaning (DE)
(72) Erfinder: SIGL, Georg, 85579 Neubiberg (DE)
(74) Vertreter: Bardehle Pagenberg Partnerschaft mbB Patentanwälte Rechtsanwälte

(57) **Zusammenfassung**

Die vorliegende Erfindung betrifft ein Verfahren zum Beschichten eines Substrats, insbesondere eines supraleitenden Bandleiters, in einer Vakuumumgebung, aufweisend: Erzeugen eines metallischen Materials in der Gasphase, Einleiten des gasförmigen metallischen Materials in einen Expansionsraum, wobei der Expansionsraum dazu eingerichtet ist, das gasförmige metallische Material expandieren zu lassen und auf das Substrat zu richten und Abscheiden des metallischen Materials auf zumindest einem Teil der Oberfläche des Substrats.

Ferner betrifft die vorliegende Erfindung einen beschichteten supraleitenden Bandleiter, aufweisend: zumindest eine supraleitende Schicht und zumindest eine metallische Beschichtung, die auf dem Bandleiter abgeschieden ist, wobei die Dicke der metallische Beschichtung zumindest 1µm beträgt und über die Breite des beschichteten Bandleiters nicht mehr als 10%, bevorzugt nicht mehr als 5% variiert.

## Beschreibung

### 1. Technisches Gebiet

Die vorliegende Erfindung betrifft ein Verfahren und eine Vorrichtung zur Metallbeschichtung von Substraten, insbesondere von hitzeempfindlichen, dünnen Substraten, wie Folien, Belts für die Elektronik und Hochtemperatur-Supraleiter (HTS) Bandleitern. Insbesondere sollen dichte, elektrisch gut leitfähige Metallschichten, z.B. aus Edelmetallen wie Gold, Silber, Kupfer, Zinn und deren Legierungen (z.B. Bronze) mit hoher Abscheiderate und hoher Materialausbeute auf derartige Substrate abgeschieden werden.

### 2. Stand der Technik

Zur Abscheidung metallischer Schutz- oder Kontaktschichten sind verschiedenste Verfahren aus dem Stand der Technik bekannt. Bei metallischen Substraten wird häufig eine galvanische Abscheidung angewandt, da sich dabei Material selektiv auf der Substratoberfläche ablagert und damit eine hohe Materialausbeute gewährleistet werden kann.

Für dicke Metallschichten werden häufig auch das sog. Plasmaspritzen oder Siebdruckpasten mit metallischen Nanopartikeln verwendet. Das Plasma- oder auch das Partikelspritzen findet üblicherweise bei Atmosphärendruck statt. Um eine Richtwirkung zu erzielen, wird dabei gelegentlich auch mit Düsen gearbeitet. Beim Sprühen kalter Teilchen schlägt die WO 2008074064 A1 die Verwendung einer Düse vor, um die von einem Prozessgas mitgeführten Partikel eines Pulvers mit hoher kinetischer Energie auf das Substrat zu lenken. Diese Anwendung ist auf hohe Gasdrücke des Prozessgases beschränkt, da das Prozessgas die mitgeführten Pulverpartikel durch Stöße beschleunigen muss.

Für dünne Schichten werden üblicherweise PVD (physical vapour deposition) - Techniken verwendet - wie etwa Sputtern oder Aufdampfen im Hochvakuum aus beheizten Schiffchen oder Tiegeln. Damit lassen sich sehr dichte, glatte Metallschichten herstellen, die jedoch oft nur eine sehr geringe Dicke aufweisen.

Um dabei eine ausreichende Wärmeabfuhr zu gewährleisten, kann man beispielswiese Foliensubstrate im Beschichtungsbereich über eine gekühlte Walze führen und die Wärme nach hinten abführen. Eine solche Anordnung ist beispielhaft in der US 7,871,667 beschrieben. Dies hat jedoch den Nachteil, dass im Beschichtungsbereich durch den Kreisbogen eine beträchtliche Variation des Auftreffwinkels auftritt, was lokal zu Abschattungseffekten und säulenartigem Wachstum der Schicht führen kann.

All diese Verfahren haben jedoch auch weitere spezifische Nachteile, insbesondere wenn das Substrat gegen aggressive Chemikalien und / oder hohe Temperaturen empfindlich ist. So werden in der Galvanik meist aggressive Elektrolyten (stark sauer, oder cyanidisch) eingesetzt, die empfindliche Substrattypen oder Beschichtungen angreifen können. Zudem muss die Substratoberfläche überall eine gute elektrische Leitfähigkeit besitzen, damit die Abscheidung gleichmäßig erfolgt. An Ecken und Kanten des Substrats kommt es dabei durch Feldüberhöhung fast unweigerlich zu Verdickungen, dem sog. Hundeknochen-Effekt, so dass die Beschichtung vor allem bei dünnen Substraten an den Kanten nicht gleichmäßig ist. Derartige ungleichmäßig beschichtete Substrate können daher für Anwendungen wie dicht gepackte Magnetspulen schlecht geeignet sein.

Zudem wird bei der Elektrolyse auch Wasserstoff freigesetzt und ins Metall eingelagert, was die Materialeigenschaften (z.B. von Kupfer) verändern kann (z.B. über Wasserstoffversprödung). Ferner besteht vor allem bei folien- oder bandförmigen Subtraten, die bereits andere Funktionsschichten tragen, wie das z.B. bei HTS-Bandleitern der Fall sein kann, die Gefahr von Flüssigkeitseinlagerungen in Taschen oder Hohlräumen. Dies kann zu Korrosion oder Blasenbildung (sog. *Ballooning*) beim Löten führen.

Plasmaspritzen erzeugt lokal einen hohen Wärmeeintrag und führt zu sehr porösen Schichten, verbietet sich also für empfindliche Substrate. Auch Siebdruckpasten oder Tinten müssen nach dem Auftrag einer thermischen Behandlung unterzogen werden, um organische Lösungsmittel auszutreiben und weisen danach eine hohe Porendichte auf. Eine konforme bzw. homogene Ummantelung des Substrats ist damit schwierig zu erreichen und die Haftung an Kanten problematisch.

Nasschemische Beschichtungsverfahren oder Plasmaspritz- oder Partikelsprühverfahren mit denen auch dicke Metallschichten aufgebracht werden können, liefern durchweg Schichten mit hoher Porosität und Oberflächenrauigkeit, da dort vorhandene Metallpartikel miteinander verbacken werden. Der Partikeldurchmesser bestimmt damit auch die Größe von Zwischenräumen und der Oberflächenbeschaffenheit.

PVD - Verfahren liefern hingegen bei niedrigen Abscheideraten von einigen nm/s und Substrattemperaturen < 100°C sehr homogene, glatte und dichte Schichten. Beim Sputtern befindet sich das Substrat jedoch sehr nahe am Plasma und die hochenergetischen Ionen führen zu hohem Wärmeeintrag. Neben Metallatomen und Ionen können beim Sputtern auch Cluster von Metall-Fragmenten freigesetzt werden. Dadurch wachsen Metallschichten deutlich rauer als beim Verdampfen, wo die Verdampfungsquelle weit entfernt vom Substrat ist und die Metallatome mit thermischen Geschwindigkeiten auftreffen.

Bei niedriger Beschichtungsrate sind diese PVD - Verfahren jedoch für die Herstellung dickerer Metallauflagen von mehr als 1 µm - 3 µm im Allgemeinen nicht wirtschaftlich.

PVD-Methoden im Vakuum werden üblicherweise für dünne Metallschichten eingesetzt. Aus Gründen der Wirtschaftlichkeit sind hohe Abscheideraten wünschenswert, allerdings neigen bei PVD-Schichten bei hohen Abscheideraten und kalter Substratunterlage durch lokale Abschattungseffekte zu säulenartigem Wachstum, so dass raue und poröse Schichten entstehen.

Dieses Phänomen ist in der Literatur sehr gut belegt. Siehe z.B. Donald M. Mattox, "Handbook of physical vapour deposition (PVD) processing", ISBN: 0-8155-1422-0, 1998, S. 498ff. und kann durch das Zonenmodell von B.A. Movchan, A.V. Demchishin, Fiz. Met. Metalloved. 28 (1969) 653 beschrieben werden. Der extreme Hochratenbereich mit einer Abscheiderate von > 50 nm/s ist mit Sputtern selbst bei gut leitfähigen Metalltargets mit konventionellen PVD-Methoden nicht zugänglich.

In der DE 10 2009 019146 sind Maßnahmen beschrieben, um den an die Kammerwände einer Beschichtungskammer gerichteten Metalldampft in die Kammer zurück zu streuen und so die Ausbeute zu erhöhen. Allerdings trifft dadurch und durch die ballistische Ausbereitung des Dampfes von der Quelle ein Großteil der Metallatome ungerichtet und zum Teil unter sehr flachen Winkeln auf das Substratband. Die notwenige niedrige Substrattemperatur und das flache Auftreffen bei hoher Beschichtungsrate führen, wie oben beschrieben, unweigerlich zu einem säulenartigen Wachstum der Beschichtung. Dadurch kann die Schicht mit tiefen Spalten und Poren durchsetzt sein und ihre Hermetizität (Schutzfunktion) und elektrische Leitfähigkeit können dadurch stark beeinträchtigt sein.

Die vorliegende Erfindung soll zumindest einige der geschilderten Nachteile des Stands der Technik überwinden und damit eine ökonomische Alternative für die Abscheidung von homogenen, dichten Metallschichten mit hoher Abscheiderate und verbesserter Materialausbeute anbieten. Insbesondere sollen damit HTS Bandleiter sehr kostengünstig mit stabilisierenden Metallschichten oder -umhüllungen versehen werden können.

### 3. Zusammenfassung der Erfindung

Die oben angeführten Probleme werden zumindest teilweise durch den Gegenstand der unabhängigen Ansprüche der vorliegenden Erfindung gelöst. Beispielhafte Ausführungsformen sind der Gegenstand der abhängigen Ansprüche.

In einer Ausführungsform stellt die vorliegende Erfindung ein Verfahren zum Beschichten eines Substrats, insbesondere eines supraleitenden Bandleiters, in einer Vakuumumgebung bereit, wobei das Verfahren die folgenden Schritte umfasst: Erzeugen eines metallischen Materials in der Gasphase, Einleiten des gasförmigen metallischen Materials in einen Expansionsraum, wobei der Expansionsraum dazu eingerichtet ist, das gasförmige metallische Material expandieren zu lassen und auf das Substrat zu richten und Abscheiden des metallischen Materials auf zumindest einem Teil der Oberfläche des Substrats.

Insbesondere kann der Expansionsraum dazu eingerichtet sein, zumindest eine laterale Impulskomponente der Teilchen des gasförmigen metallischen Materials in eine longitudinale Impulskomponenten in Richtung des Substrats umzuwandeln und / oder dazu eingerichtet sein, eine überschallschnelle Strömung des gasförmigen metallischen Materials in Richtung des Substrats zu erzeugen und / oder dazu eingerichtet sein, die Teilchen des gasförmigen metallischen Materials so auf das Substrat zu richten, dass sie unter einem Winkel von nicht mehr als 15°, bevorzugt von nicht mehr als 10° und am meisten bevorzugt von nicht mehr als 5° zur Flächennormalen des Substrats auftreffen.

Die Erfindung kann beispielsweise bei der Beschichtung einer Substratoberfläche im Hochvakuum durch Verdampfen eines Metalls aus einem Tiegel oder einer Effusionszelle zur Anwendung kommen. Der Tiegel der Verdampfungsquelle bzw. der Gasquelle kann durch gängige Mittel wie Widerstandsheizung, Induktion oder einen Elektronenstrahl so weit aufgeheizt werden, dass das zu verdampfende Metall darin schmilzt und innerhalb des Tiegels ein gasförmiges metallisches Material erzeugt wird.

Das beschriebene Verfahren zeichnet sich durch sehr hohe Abscheideraten und Materialausbeute aus, was wiederum zu hohem Durchsatz und günstigen Produktionskosten führt. Das Verfahren vermeidet auch das bei hohen Beschichtungsraten oft auftretenden säulenartige und poröse Schichtwachstum und führt im Ergebnis zu einer dichten, glatten, und homogen dicken Metallschicht, die der Substratform vor allem auch an Kanten gut folgt und damit auch zur homogenen Rundum-Beschichtung benutzt werden kann.

Das oben beschriebene Verfahren ermöglicht es Substrate wie etwa HTS-Bandleiter mit einer sehr homogenen, dichten, hermetischen und gut leitfähigen Metallbeschichtung zu versehen, wobei Beschichtungsdicken von mehr als 1 µm bei Abscheideraten von mehr als 20nm/s, mehr als 50 nm/s und sogar von mehr als > 80 nm/s erreicht werden können.

Zusätzlich kann durch das beschriebene Verfahren auch eine sehr hohe Materialausbeute (d.h. Verhältnis von abgeschiedenem Material auf dem Substrat zu der verdampften Materialmenge) von mehr als 50%, mehr als 70%, und sogar von mehr als 80% erzielt werden. Ferner kann dadurch erreicht werden, dass die erzeugte Beschichtung im Wesentlichen keine Poren oder Spalten aufweist.

Ferner kann in der Vakuumumgebung ein Hintergrundgasdruck von höchstens 1 x 10⁻¹ Pascal, bevorzugt von höchstens 1 x 10⁻² Pascal und mehr bevorzugt von höchstens 1 x 10⁻³ Pascal vorliegen.

Dies reduziert unerwünschte Oxydation des Beschichtungsmaterials und / oder des Substrats. Ferner kann dadurch auch die Wasserstoffeinlagerung im Substrat und / oder der Beschichtung reduziert werden.

In alternativen Ausführungsformen kann das Verfahren auch in einer geeigneten Inertgasumgebung (z.B. Ar, N₂, etc.) ausgeführt werden.

Ferner kann das Substrat an einer Austrittsöffnung des Expansionsraums, vorzugsweise kontinuierlich, vorbeibewegt werden, was es erlaubt auch folien- oder bandförmige Substrate beliebiger Länge zu beschichten.

In einigen Ausführungsformen können die Teilchen des gasförmigen metallischen Materials beim Ausströmen aus der Gasquelle eine mittlere freie Weglänge von weniger als 1 mm, bevorzugt von weniger als 0,1 mm und mehr bevorzugt von weniger als 0,05 mm aufweisen. Ferner kann der Dampfdruck des metallischen Materials in der Gasquelle zumindest 10¹ Pascal, bevorzugt zumindest 10² Pascal und mehr bevorzugt zumindest 10³ Pascal betragen.

Solche Prozessparameter führen dazu, dass sich das gasförmige metallische Material durch häufige Kollisionen und Wechselwirkung untereinander näherungsweise wie ein klassisches Gasensemble verhält. Die Expansion des gasförmigen metallischen Materials im Expansionsraum kann dabei Wärmeenergie in Bewegungsenergie umwandeln und ggf. eine Überschallströmung in Richtung des Substrates erzeugen. Laterale Impulskomponenten der Metallteilchen werden dabei in Vorwärtskomponenten umgewandelt und der Gasfluss parallel zur Achse des Expansionsraums auf das Substrat ausgerichtet.

In einer weiteren Ausführungsform stellt die vorliegenden Erfindung eine Vorrichtung zum Beschichten eines Substrats, insbesondere eines supraleitenden Bandleiters bereit, wobei die Vorrichtung umfasst: eine Gasquelle zum Erzeugen eines metallischen Materials in der Gasphase; wobei die Gasquelle eine Öffnung aufweist, aus der das gasförmige metallischen Materials in einen Expansionsraum strömt und wobei der Expansionsraum dazu eingerichtet ist, das gasförmige metallische Material expandieren zu lassen und auf das Substrat zu richten.

Ferner kann wie oben bereits beschrieben, der Expansionsraum dazu eingerichtet sein, zumindest eine laterale Impulskomponente der Teilchen des metallischen Materials in eine longitudinale Impulskomponente in Richtung des Substrats umzuwandeln und / oder dazu eingerichtet sein, eine überschallschnelle Strömung des gasförmigen, metallischen Materials in Richtung des Substrats zu erzeugen und / oder dazu eingerichtet sein, die Teilchen des gasförmigen metallischen Materials so auf das Substrat zu richten, dass sie unter einem Winkel von nicht mehr als 15°, bevorzugt von nicht mehr als 10° und am meisten bevorzugt von nicht mehr als 5° zur Flächennormalen des Substrats auftreffen.

Insbesondere kann die Vorrichtung eine den Expansionsraum umgebende Mantelfläche umfassen, wobei zumindest ein Teil der Mantelfläche eine Anti-Haftbeschichtung, vorzugsweise eine Perfluorpolyether, PFPE, -Antihaftbeschichtung aufweisen kann. Ferner kann zumindest ein Teil der Mantelfläche derart behandelt sein, dass die Absorption von Wärmestrahlung erhöht ist. Ferner kann zumindest ein Teil der Mantelfläche aktiv gekühlt sein.

Dies führt beispielsweise dazu, dass sich das gasförmige metallische Material nicht auf der Mantelfläche des Expansionsraums niederschlägt. Geeignete Anti-Haft-Beschichtungen vom Typ langkettiger Perfluorpolyether (PFPE) sind z.B. aus der US 4,022,928 bekannt. Der ummantelte Expansionsraum hat dabei zwei entscheidende Vorteile. Der Metalldampfstrom wird parallelisiert, so dass auch bei einer hohen Beschichtungsrate und niedriger Substrattemperatur ein kompaktes Schichtwachstum erreicht wird. Zum zweiten wird die Materialausbeute stark erhöht, so dass selbst bei großem Abstand zwischen Verdampfungsquelle und Substrat im Hochvakuum mehr als 50%, mehr als 70% und sogar über 80% des verdampften Metalls auf dem Substrat abgeschieden wird. Die aktive Kühlung schützt dabei die Anti-Haftbeschichtung vor Überhitzen und - zusammen mit der erhöhten Absorption von Wärmestrahlung - reduziert den bei manchen Substrattypen (z.B. bei HTS-Bandleitern) ungewollten Wärmeeintrag durch die Wärmestrahlung der Gasquelle. Insbesondere kann dadurch erreicht werden, dass selbst bei sehr hohen Abscheideraten hitzeempfindliche Substrattypen nicht überhitzen und die Substrattemperatur während der Beschichtung unterhalb von 180°C oder gar unterhalb von 150° bleibt.

Alternativ kann bei weniger temperaturempfindlichen Substrattypen zumindest ein Teil der Mantelfläche auch eine Temperatur aufweisen, bei der eine Ablagerung des metallischen Materials auf der Mantelfläche reduziert ist.

Ferner kann der Expansionsraum in einigen Ausführungsformen eine dem Substrat zugewandte Austrittsöffnung sowie eine der Gasquelle hin zugewandte Eintrittsöffnung aufweisen, wobei das Verhältnis der Durchmesser der Austrittsöffnung und der Eintrittsöffnung zumindest 1.5, bevorzugt zumindest 1.75 und mehr bevorzugt zumindest 2.0 betragen kann und / oder wobei das Verhältnis aus dem Abstand zwischen der Eintrittsöffnung und dem Substrat und dem Abstand zwischen der Eintrittsöffnung und der Austrittsöffnung zumindest 1.0, und höchstens 1.4 betragen kann und / oder wobei das Verhältnis aus dem Abstand zwischen der Austrittsöffnung und der Eintrittsöffnung und dem Durchmesser der Austrittsöffnung zumindest 1.5 betragen kann.

Es hat sich gezeigt, dass diese geometrischen Eigenschaften des Expansionsraums die Richtwirkung des Expansionsraumes vorteilhaft beeinflussen können. Insbesondere kann dadurch eine homogenes, dichtes und porenfreies Schichtwachstum auch bei hohen Beschichtungsraten gewährleistet werden.

Ferner kann sich in einigen Ausführungsformen der Expansionsraum von der Gasquelle zum Substrat hin verbreitern, insbesondere konisch oder glockenförmig verbreitern. Insbesondere kann der Expansionsraum die Form eines divergenten Teils einer Lavaldüse aufweisen.

Derartige Lavaldüsen, oder Überschalldüsen werden in der Raketentechnik benutzt um in Raketentriebwerken gerichtete Gasströme zu erzeugen, die unter hohem Druck erzeugt in den freien Raum expandieren. Um einen möglichst hohen gerichteten Vorwärtsschub zu erzeugen, wird dabei die expandierende Gasströmung in einer Laval-Düse parallelisiert.

Die beschriebene Ausführungsform überträgt dieses Prinzip auf den Einsatz einer Vakuumumgebung, obwohl dabei die Gasdrücke um viele Größenordnungen unter denen eines Raketentriebwerks liegen. Wie oben bereits diskutiert kann es zur Erzeugung einer Überschallströmung bereits genügen, dass der Gasdruck im Dampf der Metallatome am Ausgang der Gasquelle im Hochratenbetrieb im Bereich von 10² Pascal liegt und damit die mittlere freie Weglänge im Metalldampf im Sub-Millimeterbereich, so dass er sich durch häufige Kollisionen und Wechselwirkung der Atome wie ein klassisches Gasensemble verhält. Die Entspannung des Gases (Metalldampfes) im divergenten Teil der Lavaldüse setzt Wärmeenergie in Bewegungsenergie um und bildet eine Überschallströmung. Laterale Impulskomponenten der Metallatome werden dabei in Vorwärtskomponenten umgewandelt und der Gasfluss parallel zur Düsenachse ausgerichtet. Dabei ist die mittlere freie Weglänge im expandierenden Gas vorzugsweise deutlich kleiner als die geometrischen Abmessungen der Lavaldüse. Um diesen Effekt effizient zu nutzen wird in einigen Ausführungsformen der vorliegenden Erfindung im Raum zwischen Verdampfungsquelle und Substratbeschichtungsebene ein Expansionsraum eingefügt der dem divergenten Teil (Expansionsteil) der Laval-Düse entspricht. Der konische oder glockenartige Expansionsraum kann einen runden bis leicht elliptischen Durchmesser haben, um sich der Geometrie der Beschichtungsfläche anzupassen.

Insbesondere kann in einigen Ausführungsformen der Expansionsraum einen elliptischen oder einen rechteckigen Querschnitt aufweisen, der ein Aspektverhältnis von zumindest 1,2, bevorzugt von zumindest 1,5, mehr bevorzugt von zumindest 2,0 und am meisten bevorzugt von zumindest 3,0 aufweist.

So kann der Strömungsquerschnitt des aus dem Expansionsraum in Richtung des Substrats strömenden gasförmigen metallischen Materials an die längliche Form eines folien- oder bandförmigen Substrats angepasst werden und damit die nutzbare Beschichtungsfläche auf dem Substrat erhöht werden.

Ferner kann die Öffnung der Gasquelle eine Öffnungsblende aufweist, die vorzugsweise zumindest eine Lamelle aufweist. Ferner kann die Gasquelle und / oder die Öffnungsblende aus einem Material mit hohem Schmelzpunkt vorzugsweise aus Wolfram, Tantal, Molybdän, Kohlenstoff und /oder einer hitzebeständigen Keramik gefertigt sein.

Dadurch kann der Aufbau des Dampfdrucks in der Gasquelle verstärkt werden. Die bevorzugt lamellenförmige Blende reduziert dabei auch das Herausspritzen flüssiger Metalltröpfchen aus der Gasquelle, die durch Überhitzung und / oder turbulente Strömungsvorgänge entstehen können.

In einer weiteren Ausführungsform stellt die vorliegende Erfindung ein System zum Beschichten eines Substrats, insbesondere eines supraleitenden Bandleiters bereit, wobei das System umfasst: zumindest eine Beschichtungszone, in der ein metallisches Material auf dem Substrat abgeschieden wird, wobei das Substrat die zumindest eine Beschichtungszone zumindest zweimal durchläuft oder zumindest zwei Beschichtungszonen, in denen das metallisches Material auf dem Substrat abgeschieden wird, wobei das Substrat die zumindest zwei Beschichtungszonen zumindest jeweils einmal durchläuft.

Ein solches System kann es beispielsweise ermöglichen, in einem einzigen Prozessschritt dickere Schichten auf dem Substrat abzuscheiden.

Insbesondere kann das System auch Mittel zum Ändern der Orientierung des Substrats nach einem ersten und vor einem zweiten Durchlauf durch die zumindest eine Beschichtungszone oder vor dem Durchlauf durch die zweite Beschichtungszone umfassen.

Ein solches System kann es beispielsweise ermöglichen, dass beide Seiten eines bandförmigen Substrats, wie etwa eines HTS-Bandleiters gleichmäßig beschichtet werden; insbesondere auch dann, wenn wie mit einigen der oben beschriebenen Vorrichtungen ein Strom von Beschichtungsmaterialteilchen auf das zu beschichtende Substrat gerichtet wird.

In einer weiteren Ausführungsform stellt die vorliegende Erfindung ein System zum Beschichten eines Substrats, insbesondere eines supraleitenden Bandleiters, bereit, wobei das System umfasst: zumindest eine Beschichtungszone, in der ein metallisches Material auf dem Substrat abgeschieden wird, wobei das Substrat die zumindest eine Beschichtungszone zumindest zweimal durchläuft oder zumindest zwei Beschichtungszonen, in denen das metallisches Material auf dem Substrat abgeschieden wird, wobei das Substrat die zumindest zwei Beschichtungszone zumindest jeweils einmal durchläuft und Mittel zum Kühlen des Substrats nach einem ersten und vor einem zweiten Durchlauf durch die zumindest eine Beschichtungszone oder vor dem Durchlauf durch die zweite Beschichtungszone.

Bei der Hochratenbeschichtung besteht der Hauptwärmeintrag auf das Substrat in der Kondensationsenergie, die bei der Schichtbildung frei wird. Da sich das Substrat in einigen Ausführungsformen auch im Hochvakuum befinden kann, kann es diesen Wärmeeintrag nicht über Festkörper- oder Gaswärmeleitung abgeben und heizt sich abhängig von seiner Wärmekapazität auf. Diese ist insbesondere bei dünnen Folien und Bändern sehr niedrig, was bei Temperatur-empfindlichen Substraten die maximale Schichtdicke begrenzt, die pro Durchlauf durch die zumindest eine Beschichtungszone abgeschieden werden kann. Im Falle von HTS-Bandleitern sollte z.B. die Maximaltemperatur in einer Vakuumumgebung unter 180°C, bevorzugt unter 150°C bleiben, da oberhalb dieser Temperatur durch Sauerstoffverlust eine Verschlechterung der HTS-Schichteigenschaften, insbesondere der kritischen Stromtragfähigkeit eintreten kann.

Die beschriebene Ausführungsform ermöglicht es nun auch Metallschichten von mehr als 1 µm Dicke abzuscheiden, indem das Substrat mehrfach durch die Beschichtungszone geführt und dazwischen durch das Kühlmittel abgekühlt wird. Insbesondere kann in einigen Ausführungsformen die Geschwindigkeit mit der das Substrat die Beschichtungszone(n) durchläuft so gewählt werden, dass beim einmaligen Durchlauf der Beschichtungszone die Temperatur unterhalb einer gewünschten Schwellentemperatur bleibt. Danach kann das Substrat dann das Mittel zum Kühlen durchlaufen, bevor es eine weitere oder dieselbe Beschichtungszone wiederholt durchläuft. Diesen Vorgang kann beliebig oft fortgesetzt werden, bis die angestrebte Gesamtschichtdicke erreicht ist. Die Zwischenkühleinrichtung kann auch außerhalb der Beschichtungszone(n) liegen und kann von dieser effektiv abgekoppelt werden. Dort kann z.B. über gekühlte Walzen und Festkörperwärmeleitung oder über erhöhte Gaswärmeleitung das Substrat soweit herunter gekühlt werden, dass die Einlauftemperatur tief genug liegt, den Temperaturhub bei der Beschichtung auszugleichen.

In einer weiteren Ausführungsform stellt die vorliegende Erfindung ein System zum Beschichten eines Substrats, insbesondere eines supraleitenden Bandleiters, bereit, wobei das System umfasst: zumindest eine Beschichtungszone, in der ein metallisches Material auf dem Substrat abgeschieden wird, wobei das Substrat die zumindest eine Beschichtungszone zumindest zweimal durchläuft oder zumindest zwei Beschichtungszonen, in denen das metallisches Material auf dem Substrat abgeschieden wird, wobei das Substrat die zumindest zwei Beschichtungszone zumindest jeweils einmal durchläuft und zumindest einen in der oder um die zumindest eine Beschichtungszone angeordneten Gasreflektor, der Teilchen des metallischen Materials in Richtung des Substrats reflektiert.

Insbesondere kann zumindest ein Teil des zumindest einen Gasreflektors eine Anti-Haftbeschichtung aufweisen und / oder zumindest ein Teil des zumindest einen Gasreflektors derart behandelt sein, dass die Absorption von Wärmestrahlung erhöht ist und / oder zumindest ein Teil des Gasreflektors aktiv gekühlt sein.

Ein solcher Gasreflektor erhöht signifikant die Materialausbeute des Systems, führt dazu dass das Substrat von allen Richtungen aus homogener beschichtet wird und / oder reduziert den Wärmeeintrag in das Substrat.

Insbesondere kann in einigen Ausführungsformen das Abscheiden des metallischen Materials in der oder in den Beschichtungszonen der oben beschriebenen Systeme unter Verwendung einer der oben beschriebenen Vorrichtungen und / oder Verfahren erfolgen.

Insbesondere lassen sich die oben beschriebenen Systeme auch untereinander kombinieren, sodass je nach Anwendungsgebiet des Beschichtungssystems sowohl ein Orientierungswechsel des Substrats, eine Zwischenkühlung und /oder der beschriebene Gasreflektor zum Einsatz kommen kann.

In einer weiteren Ausführungsform stellt die vorliegende Erfindung einen beschichteten supraleitenden Bandleiter bereit, umfassend: zumindest eine supraleitende Schicht, zumindest eine metallische Beschichtung, die auf dem Bandleiter abgeschieden ist, wobei die Dicke der metallische Beschichtung zumindest 1 µm beträgt und über die Breite des beschichteten Bandleiters nicht mehr als 10%, bevorzugt nicht mehr als 5% variiert.

Ein solcher supraleitender Bandleiter eignet sich besonders für solche Anwendungen, in denen mehrere Bandleiter übereinandergestapelt sind oder wenn wie bei einer Magnetspule mehrere übereinanderliegende Wicklungen vorkommen. Die niedrige Dickenvariation des Bandleiters reduziert Hohl- bzw. Zwischenräume und / oder Verspannungen zwischen den einzelnen Lagen / Wicklungen. Ferner versiegelt die Dicke der Beschichtung von über 1 µm die supraleitende Schicht, ermöglicht eine gute thermische Leitungskühlung und stellt bei lokalem Zusammenbrechen (*Quenschen*) der Supraleitung einen wirksamen alternativen Strompfad bereit.

Insbesondere kann die zumindest eine metallische Beschichtung des Bandleiters mit einem der oben beschriebenen Verfahren, Vorrichtungen und / oder Beschichtungssystemen erzeugt worden sein.

Ferner kann in einigen Ausführungsformen das Volumen der zumindest eine metallische Beschichtung zu weniger als 5 %, bevorzugt zu weniger als 3% und mehr bevorzugt zu weniger als 1% aus Hohlräumen, Spalten und / oder Poren bestehen.

Ferner kann in einigen Ausführungsformen die Flächendichte von in der metallischen Beschichtung eingelagerten oder auf der metallischen Beschichtung abgelagerten Metallpartikeln mit einem durchschnittlichen Durchmesser von zumindest 10 µm, kleiner als 5/cm², bevorzugt kleiner als 3/cm², mehr bevorzugt kleiner als 1/cm² und am meisten bevorzugt kleiner als 0,1 / cm² sein

Ferner kann die metallische Beschichtung Gold, Silber, Kupfer und / oder Zinn, deren Legierungen oder einer Abfolge dieser Metalle aufweisen und / oder den Bandleiter einhüllen.

Ferner kann die Dicke der zumindest einen eine metallische Beschichtung, zumindest 1 µm und höchstens 30 µm, bevorzugt zumindest 1 µm und höchstens 10 µm und mehr bevorzugt zumindest 3 µm und höchstens 10 µm betragen.

Die durch die vorliegende Erfindung erreichbare Homogenität und Reinheit der Beschichtung erhöht die elektrische und thermische Leitfähigkeit der Beschichtung und verbessert deren Hermetizität und mechanische Eigenschaften. Beispielsweise splittert eine homogene und reine Beschichtung seltener vom Substrat ab.

### 4. Beschreibung der Zeichnungen

Ausgewählte Aspekte der vorliegenden Erfindung werden im Folgenden mit Bezugnahme auf die angefügten Zeichnungen beschrieben. Diese Zeichnungen zeigen:
- **Fig. 1**: einen schematischen Aufbau einer Anordnung zur PVD Metallisierung von Substraten nach einer Ausführungsform der vorliegenden Erfindung;
- **Fig. 2**: einen schematischen Aufbau einer Anordnung zur PVD Metallisierung von bandförmigen Substraten mit einer Wickleranordnung nach einer Ausführungsform der vorliegenden Erfindung;
- **Fig. 3a**: eine Querschnittspräparation eines konventionellen, galvanisch verkupferten HTS Bandleiters;
- **Fig. 3b**: eine Querschnittpräparation der Kante eines HTS Bandleiters mit umlaufender Kupferbeschichtung nach einer Ausführungsform der vorliegenden Erfindung;
- **Fig. 4a**: eine Querschnittspräparation einer 12 µm dicken Silberschicht, die mit einem konventionellen Hochraten - PVD Verfahren hergestellt wurde;
- **Fig. 4b**: eine Querschnittspräparation einer 12 µm dicken Kupferschicht gemäß einer Ausführungsform der vorliegenden Erfindung.

**In den Zeichnungen werden folgende Bezeichnungen verwendet:**
- 1: Vakuumkammer / -umgebung
- 2: Verdampfungsquelle / Gasquelle
- 3: Wassergekühlter Expansionsraum / Expansionsdüse
- 4: Bewegtes Substratband (Folie)
- 5: Beschichtungszone
- 6: Bandwickler / Wickleranordnung
- 7a, 7b: Wassergekühlter Rückseitenreflektor / Gasreflektor
- 8: Zwischenkühleinrichtung
- D: Abstand Verdampfungsquelle - Substratband
- L: Länge des Expansionsraum / der Expansionsdüse
- Oᵢ: Eintrittsdurchmesser des Expansionsraums
- Oₐ: Austrittsdurchmesser des Expansionsraums

### 5. Detaillierte Beschreibung einiger Ausführungsbeispiele

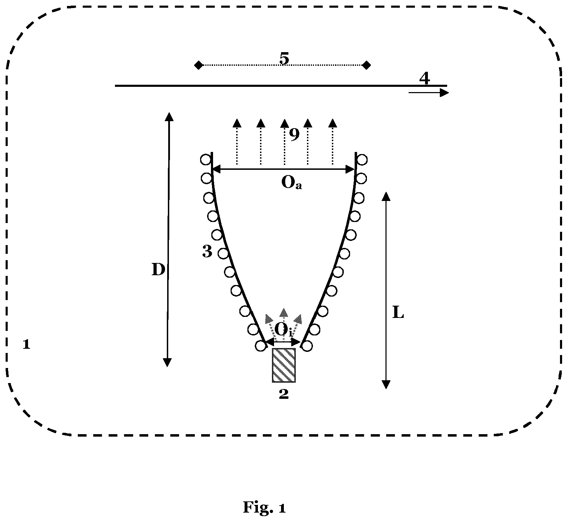

Eine erste Ausführungsform der vorliegenden Erfindung ist in Fig. 1 skizziert. Eine Vakuumanlage /-kammer 1 wird auf einen Restgasdruck von weniger als 10⁻² Pascal, bevorzugt von weniger als 10⁻³ Pascal abgepumpt, damit reaktive Metalle (z.B. Al, Mg etc.) beim Verdampfen nicht oxidieren. In der Kammer 1 befindet sich eine Verdampfungsquelle / Gasquelle 2 zum spritzerfreien Verdampfen von Metallen. Dabei kann es sich beispielsweise um eine Effusionszelle oder einen Tiegel handeln, der durch einen Elektronenstrahl, einen Widerstandheizer oder eine Induktionsspule geheizt werden kann, bis das Verdampfungsmaterial schmilzt und in der Quelle einen hohen Dampfdruck in der Größenordnung von über 10² Pascal erreicht. Bevorzugt besitzt dieser Verdampfer 2 eine Deckelblende mit Lamellen aus einem hochschmelzenden Material wie W, Ta, Mo, C oder einer Keramik, um Spritzer zu verhindern.

Im oberen Bereich der Vakuumkammer 1 wird das zu beschichtende Substrat 4 in Form eines flexiblen, dünnen Bandes oder einer Folie kontinuierlich über der Verdampfungsquelle 2 durch die Beschichtungszone 5 bewegt. Das Band kann dabei von einer Ab- und Aufwickelvorrichtung in der Vakuumkammer stammen oder kontinuierlich in die Vakuumkammer geschleust werden, wie z.B. in der DE 10 2009 052 873 beschrieben.

Um den Metalldampf 9 im Bereich der Beschichtungszone 5 möglichst senkrecht - innerhalb einer Winkelverteilung von ±15° zur Substratnormalen - auf das Substrat 4 auftreffen zu lassen und damit das oben beschriebene Säulenwachstum und hohe Schichtporosität zu vermeiden, wird zwischen Verdampfungsquelle 2 und Beschichtungszone 5 ein Expansionsraum 3 angebracht. Dieser entspricht in der gezeigten Ausführungsform in seiner Funktion dem divergenten Expansionsteil einer Laval-Düse, die vor allem in der Luft- und Raumfahrt oder in Turbinen zur Erzeugung und Bündelung von Überschallströmungen eingesetzt wird. Der Expansionsraum bzw. die Laval-Düse 3 besitzt eine nach innen konkave Glockenform und einen runden bis leicht elliptischen Durchmesser. Die untere Eintrittsöffnung (Durchmesser Oᵢ) ist etwas breiter als der Auslass der Verdampfungsquelle 2, um sie thermisch zu entkoppeln. Die obere Austrittsöffnung (Durchmesser Oₐ) bestimmt im Wesentlichen die laterale Dimension der Beschichtungszone 5.

In einigen Ausführungsformen reicht der Expansionsraum 3 mit Länge L nahe an die Beschichtungszone 5 heran, damit im Spalt zwischen Expansionsraum 3 und Substrat 4 möglichst wenig Metalldampf 9 lateral verloren geht. Der Abstand D - L wird dabei so bemessen, dass das Substratband 4 auch bei leichtem Durchhängen nicht mit dem Expansionsraum 3 in Berührung kommt und beispielsweise durch die Anti-Haftbeschichtung kontaminiert wird. Typischerweise beträgt das Verhältnis D : L = 1 - 1.4.

Die geometrischen Verhältnisse des illustrierten Expansionsraums bzw. der Laval-Düse 3 sind wie folgt: Das Verhältnis zwischen Austritts- und Eintrittsöffnung der Düse Oₐ : Oᵢ ist dabei bevorzugt größer als 1.5, besonders bevorzugt größer als 2. Das Verhältnis von Düsenlänge zum Durchmesser der Austrittsöffnung ist größer als L : Oₐ = 1,5. Die Wirkung der Laval-Düse besteht damit in einer hohen Abscheiderate aus einem parallelen Dampfstrom 9 und einer sehr hohen Materialausbeute.

Die hier beschriebene Düsenformen (z.B. Laval-Düse) des Expansionsraumes sind jedoch nur eine mögliche Art und Weise die durch den Expansionsraum bereitgestellte Richtwirkung zu erzielen. Andere Formen und / oder Typen von Expansionsräumen sind ebenso denkbar und Teil der vorliegenden Erfindung.

Um das Anhaften und die Kondensation des Metalldampfes 9 auf der Mantelfläche des Expansionsraums 3 zu verhindern, wird dieser mit einer Anti-Haftbeschichtung versehen. Geeignete Beschichtungen bestehen vorzugsweise aus langkettigen PFPE - Verbindungen (Handelsname z.B. Fomblin). Um den Dampfdruck der PFPE - Beschichtung niedrig zu halten und die Wärmestrahlung aus der Gasquelle 2 abzuführen, ist die Mantelfläche des Expansionsraums 3 aktiv gekühlt, z.B. durch gut wärmegekoppelte, wasserdurchflossenen Leitungen. Damit die Mantelfläche des Expansionsraums 3 nicht auch die Wärmestrahlung der Gasquelle 2 auf das temperaturempfindliche Substrat 4 reflektiert, empfiehlt es sich, dessen Oberfläche vor der Anti-Haftbeschichtung zu schwärzen, so dass er die Wärmestrahlung absorbiert und ins Kühlwasser abführt.

Mit dieser Anordnung können extrem hohe Beschichtungsraten am Substrat 4 erreicht werden. Angestrebt werden aus wirtschaftlichen Gründen Beschichtungsraten von mehr als 20 nm/s, bevorzugt mehr als 50 nm/s und besonders bevorzugt mehr als 80 nm/s. Letztere können mit der vorliegenden Erfindung selbst mit Kupfer als Beschichtungsmaterial problemlos erreicht werden. Ein weiterer wichtiger wirtschaftlicher Aspekt ist die Materialausbeute, d.h. das Verhältnis der Materialmenge, die auf dem Substrat 4 abgeschieden wird zu der verdampften Materialmenge. Bei der normalerweise ungerichteten Vakuumverdampfung und bei üblichen Abständen D von Quelle 2 zu Substrat 4 zwischen 30 cm und 50 cm liegt die Materialausbeute üblicherweise meist nur im niedrigen zweistelligen Prozentbereich. Mit der vorliegenden Erfindung lassen sich problemlos Materialausbeuten von mehr als 50%, bevorzugt mehr als 70%, und besonders bevorzugt von mehr als 80% erreichen.

Eine hohe Beschichtungsrate im Vakuum bzw. Hochvakuum auf dünnen Folien oder Bändern führt zwangsläufig zu einem hohen Energieeintrag durch die freiwerdende Kondensationswärme, so dass sich das Substrat 4 sehr schnell aufheizen kann. Viele Substratmaterialien, wie Kunststoffe oder HTS-Bandleiter sind temperaturempfindlich und können bei Überschreiten einer Temperaturschwelle irreversibel geschädigt werden. Die zulässige Maximaltemperatur einerseits und die Wärmekapazität des Substrats 4 andererseits bestimmen deshalb, wie viel Material bei einem Durchlauf durch die Beschichtungszone 5 abgeschieden werden kann.

Mit der Beschichtungsrate errechnet sich damit die Transportgeschwindigkeit für das Bandsubstrat 4. Werden dickere Schichten benötigt, muss das Substrat 4 mehrfach beschichtet werden. Dies kann dadurch erfolgen, dass man mehrere Verdampfungseinheiten nacheinander anbringt, das Band in seiner ganzen Länge mehrfach durch die Anlage spult, oder das Band durch eine Wickelvorrichtung 6 mehrfach durch dieselbe Beschichtungszone 5 führt. Letzteres bietet sich vor allem für Bänder an, die schmäler sind, als die Breite der Beschichtungszone 5. Natürlich können auch alle drei Maßnahmen miteinander kombiniert werden. Zusätzlich kann bei allen Mehrfachbeschichtungen nach der Passage durch die Beschichtungszone 5 eine Zwischenkühlung 8 dafür sorgen, dass dem Bandsubstrat Wärme entzogen wird und die Temperatur soweit abgesenkt wird, dass eine erneute Beschichtung stattfinden kann.

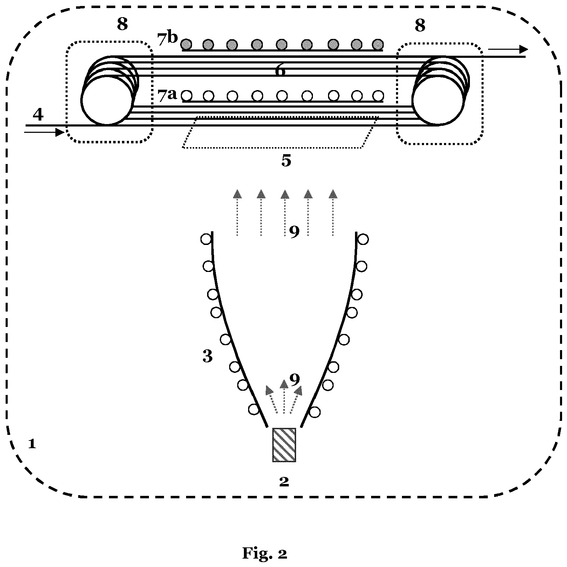

Fig 2. zeigt eine Ausführungsform eines Systems zur Beschichtung von Substraten und insbesondere von Bandleitern. Für die folgenden Untersuchungen wurden HTS Bandleiter mit 12 mm Breite rundum mit Silber und Kupfer beschichtet. HTS Bandleiter bestehen aus einem dünnen Metallband (z.B. Hastelloy C 276) mit 30 - 100 µm Dicke, auf dem metalloxidische Pufferschichten (z.B. MgO) und eine HTS-Funktionsschicht, z.B. Kuprate aus der Klasse der RBa₂Cu₃O₇ (R = Yttrium oder Seltenerd-Elemente) wie z.B. GdBa₂Cu₃O₇, abgeschieden wurden. Die Metallisierung dient der Kontaktierung, dem Schutz und der elektrischen Stabilisierung des Bandleiters, damit er bei Überlastung nicht durchbrennt.

Erwünscht ist dabei eine möglichst dichte, glatte, rundum laufende Metallisierung mit sehr guter Schichtdickenhomogenität. Die supraleitenden Kuprate neigen jedoch dazu, bei Erhitzung im Vakuum Sauerstoff durch Diffusion zu verlieren, wodurch ihre wichtigste Funktion, die kritische Stromtragfähigkeit degradiert. Die Beschichtungsvorrichtung in Fig. 2 führt den HTS Bandleiter 4 über eine Wickleranordnung 6 mit beispielsweise 15 Bahnen (im Fig. 2 nur schematisch angedeutet) mehrfach durch die Beschichtungszone 5.

Außerhalb der Beschichtungszone 5 läuft jede Bahn durch eine Zwischenkühlung 8. Auf diese Weise konnte die Substrattemperatur über die gesamte Beschichtungsdauer und bei einer Schichtdicke von mehr als 30 µm Kupfer zuverlässig unterhalb einer Temperatur von 180°C, bevorzugt sogar unterhalb 150°C gehalten werden.

Im Wickler 6 wurde zudem ein Rückseitenreflektor 7a, 7b angebracht, der das Material, dass durch die Spalten zwischen den Bahnen nach hinten dampft, bei 7a auf die Substratrückseite oder bei 7b auf die Vorderseite zurückstreut. Er ist analog zur Mantelfläche der Laval-Düse 3 wassergekühlt und mit einer Anti-Haftbeschichtung versehen. Dadurch konnte die Materialausbeute zusätzlich um ca. 10% erhöht werden. Der HTS-Bandeiter 4 wurde in diesem Fall rundum mit Kupfer umhüllt. Dafür wurde das Band beim Rücklauf durch die Anlage vertwistet, d.h. die Rückseite wurde nach vorne gebracht. Die Schichtdicken auf den beiden Hauptflächen und den Kanten des Bandes 4 können durch die Zahl Passagen, die Lage des oberen Reflektors 7a, 7b und die Breite der Zwischenräume zwischen unterschiedlichen Wicklerbahnen nach den Erfordernissen beliebig eingestellt werden.

Bei der Herstellung von HTS-Bandleitern kommen bevorzugt Metallschichten aus Silber, Kupfer, Gold und Zinn, deren Legierungen oder eine Abfolge dieser Metalle zum Einsatz. Auch wenn das hier beschriebene Verfahren nicht auf diese Metalle beschränkt ist, stehen sie doch im Fokus der Anwendung. HTS-Bandleiter wurden deshalb mit und ohne das erfindungsgemäße Verfahren mit Silber und Kupfer beschichtet und genau untersucht. Sie weisen charakteristische Merkmale auf, die eine direkte Unterscheidung zu Bandleiter möglich macht, die mit anderen Metallisierungsverfahren beschichtet werden.

So weisen galvanisch hergestellte Metallschichten auf Bandleitern an den Kanten einen charakteristischen Schichtdickenzuwachs auf, der aufgrund der elektrischen Feldüberhöhung an der Kante und dem größeren Raumwinkel, aus dem sich Metallionen anlagern können unweigerlich entsteht.

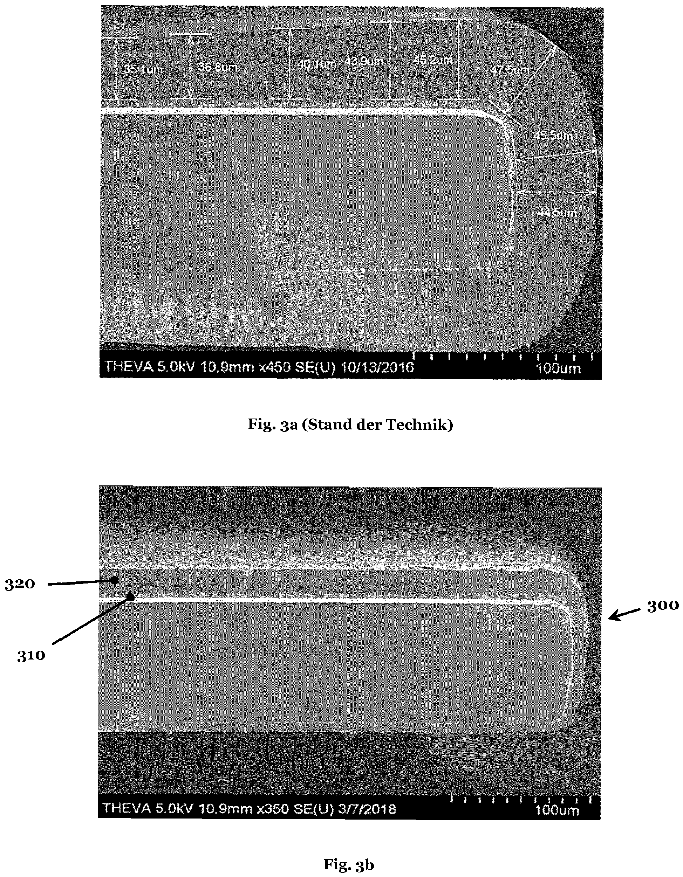

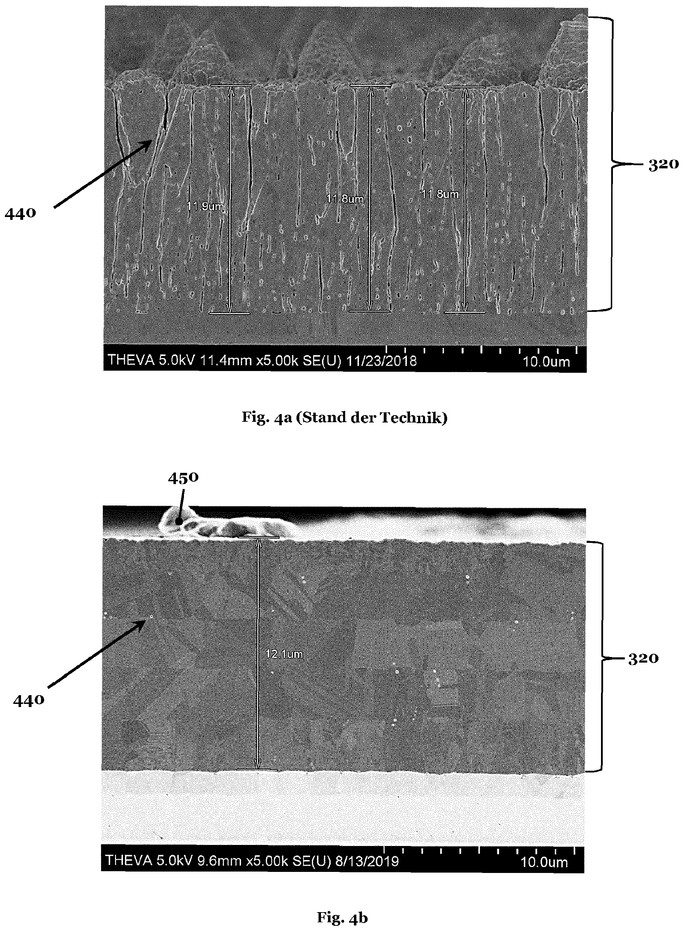

Fig. 3a zeigt exemplarisch die Querschnittspräparation der Kante eines 12 mm breiten und ca. 100 µm dicken HTS Bandleiters der konventionell, d.h. galvanisch mit einer nominal 20 µm dicken Kupferschicht beschichtet wurde. Alle gezeigten Querschnittspräparationen (Fig. 3a, 3b, 4a, 4b) wurden durch Ionenstrahlätzen mit Ar-Ionen erzeugt, um eine glatte Schnittkante ohne mechanische Beschädigung der Schichtstruktur zu gewährleisten.

Deutlich sind in der elektronenmikroskopischen Aufnahme der Schnittkante in Fig. 3a oben auf der Vorderseite des Metallsubstrats die Puffer- und HTS-Schichten als helle Bänder sichtbar. Darüber und umlaufend befindet sich die galvanisch abgeschiedene Kupferschicht. Diese ist auf dem größten Teil der Bandoberfläche mit 20 µm Dicke maßhaltig, wird aber zur Bandkante hin kontinuierlich dicker und erreicht an der Kante mit 45 µm mehr als doppelt so hohe Werte. Dieser sogenannte Hundeknocheneffekt kann zwar durch geeignete Anordnung der Anoden im Elektrolytbad reduziert werden, verschwindet jedoch bei Abscheidung wirtschaftlich interessanten mit Raten von mehrt als 20 nm/s nie ganz und ist damit ein charakteristisches Unterscheidungsmerkmal zur PVD-Beschichtung, deren Schichtdicke bis zum Rand praktisch konstant ist.

Im besten Fall beobachtet man bei galvanisch metallisierten Bandleitern ein Dickenverhältnis von Rand zu Mitte von 1,2 - 1,3. Dagegen liegt dieses Verhältnis bei den hier hergestellten PVD-Metallschichten (siehe Fig. 3b) unterhalb 1,1, bevorzugt sogar unter 1,05. Diese Maßhaltigkeit ist vor allem für den Bau von Magnetspulen erwünscht, da eine inhomogene Leiterdicke zu unnötigen Zwischenräumen zwischen den Wickellagen führt.

Fig. 3b zeigt im Vergleich dazu die Querschnittspräparation eines mit dem Hochraten PVD-Verfahren der vorliegenden Erfindung rundum mit Kupfer beschichteten Bandleiters 300. Deutlich sind in der elektronenmikroskopischen Aufnahme der Schnittkante in Fig. 3b oben auf der Vorderseite des Metallsubstrats die Puffer- und HTS-Schichten 310 als helle Bänder sichtbar. Bei dem Bandleiter von Fig. 3b wurden

Vorder- und Rückseite mit unterschiedlichen Dicken beschichtet, hier 14 µm vorne, 6 µm hinten. Die hervorragende Homogenität der Schichtdicke 320 und Kantenbedeckung sind deutlich zu erkennen. Die Variation der Metallschichtdicke 320 beträgt weniger als 10%, bevorzugt 5% vom Mittelwert.

Die vorliegende Erfindung erlaubt es somit, die hohe Qualität von PVD aufgedampften Metallschichten auch im Bereich hoher Beschichtungsraten und großer Metallschichtdicken zu erzielen. Besonders geeignet ist das Verfahren für die Metallisierung von HTS-Bandleitern, wenn dort auf jeder Seite zwischen 1-30 µm, bevorzugt zwischen 1-20 µm und besonders bevorzugt zwischen 3-20 µm an Metallschichtdicke aufgebracht werden.

Fig. 4a und 4.b zeigen im Vergleich die Ergebnisse konventioneller Hochratenverdampfung (Fig. 4a) und der vorliegenden Erfindung (Fig. 4b) anhand von zwei HTS Bandleitern, die mit 12 µm dicken Metallschichten beschichtet wurden.

Fig. 4a zeigt eine Silberschicht im Querschnitt, die mit hoher Rate > 50 nm/s und Zwischenkühlung, aber ohne den durch die vorliegende Erfindung vorgesehenen Expansionsraum 3 hergestellt wurde. Der Dampf aus der Quelle wird von den seitlichen Wänden einer Kammer in die Kammer zurück reflektiert, bis er auf dem Substrat auftrifft und dort in die Metallschicht eingebaut wird. Hierdurch gelangt der Dampf aus allen Raumrichtung (d.h. ungerichtet) bis hin zum streifenden Einfall auf die Substratoberfläche.

In Fig. 4a ist vom HTS Bandleiter unten nur die Grenzfläche zur HTS Schicht und eine 1,5 µm dünne, kristalline Silberschicht zu sehen, die nach einer ersten PVD Beschichtung bei Temperaturen >300°C getempert wurde. Ganz deutlich zeichnet sich in der Hochraten-Silberschicht in dieser Anordnung das Säulenwachstum ab, das zu großen Poren und Spalten 440 in der Schicht und charakteristischen Oberflächenstrukturen führt. Die Dickenvariation und Rauigkeit beträgt einige µm und damit mehr als 20% der mittleren Schichtdicke.

Fig. 4b zeigt hingegen den Querschnitt einer 12 µm dicken Kupferschicht 320, die auf einer vergleichbaren HTS-Bandleiteroberfläche mit der vorliegenden Erfindung abgeschieden wurde. Bei genauer Betrachtung lässt sich innerhalb der Kupferschicht 320 eine Lagenstruktur erkennen, die vom mehrfachen Durchlaufen der Beschichtungszone herrührt. Im Gegensatz zu Fig. 4a, ist diese Schicht sehr dicht und glatt. Poren und Spalten 440 wie in Fig. 4a sind fast vollständig nicht mehr vorhanden.

Bei der hier angewandten Querschnittspräparation durch Ionenstrahlätzen und elektronenmikroskopischer Betrachtung (Vergrößerung 5000×) senkrecht zur Substratoberfläche machen Hohlräume oder Poren 440 weniger als 1% der Querschnittsfläche und somit auch des Volumens der Metallschicht 320 aus. Die Dickenvariation der Metallschicht 320 gemessen an dieser Querschnittspräparation durch Ionenstrahlätzen beträgt hier zumindest weniger als 10% in einigen Ausführungsformen sogar zumindest weniger als 5% der mittleren lokalen Schichtdicke.

Die durch eine der Ausführungsformen der vorliegenden Erfindung hergestellten HTS Bandleiter 300 zeichnen sich ebenfalls auch durch eine sehr niedrige Flächendichte an Metallspritzern 450 auf der Oberfläche aus. Beim Hochraten-Verdampfen kommt es bei Tiegeln durch die starke Überhitzung oft zu turbulenten Vorgängen in der Metallschmelze und zur Spritzerbildung. Die dadurch entstehenden Metalltröpfchen 450 haben Durchmesser von > 10 µm, können das Substrat beim Auftreffen durch lokale Überhitzung schädigen oder können beim Führen des Substrats über Rollen in die darunter liegende HTS Schicht 310 gedrückt werden und diese zerbrechen. Durch eine Verdampfungsquelle mit Deckelblende aus hochschmelzendem Material wie W, Ta, Mo, C oder Keramik lassen sich Spritzer effektiv vermeiden. Die hier hergestellten Metallschichten 320 zeichnen sich deshalb ebenfalls auch durch eine sehr geringe Flächendichte < 0,1/cm² an Spritzern und eingelagerten Partikeln 450 mit einem mittleren Durchmesser von mehr als 10 µm aus.

## Patentansprüche

1. Verfahren zum Beschichten eines Substrats (4), insbesondere eines supraleitenden Bandleiters, in einer Vakuumumgebung (1), aufweisend:
a. Erzeugen eines metallischen Materials (9) in der Gasphase;
b. Einleiten des gasförmigen metallischen Materials (9) in einen Expansionsraum (3);
c. wobei der Expansionsraum (3) dazu eingerichtet ist, das gasförmige metallische Material (9) expandieren zu lassen und auf das Substrat (4) zu richten; und
d. Abscheiden des metallischen Materials (9) auf zumindest einem Teil der Oberfläche des Substrats (4).

2. Verfahren nach Anspruch 1, wobei der Expansionsraum (3) dazu eingerichtet ist, zumindest eine laterale Impulskomponente der Teilchen des gasförmigen metallischen Materials (9) in eine longitudinale Impulskomponenten in Richtung des Substrats (4) umzuwandeln; und / oder wobei
der Expansionsraum (3) dazu eingerichtet ist, eine überschallschnelle Strömung des gasförmigen metallischen Materials (9) in Richtung des Substrats (4) zu erzeugen; und / oder wobei
der Expansionsraum (3) dazu eingerichtet ist, die Teilchen des gasförmigen metallischen Materials (9) so auf das Substrat (4) zu richten, dass sie unter einem Winkel von nicht mehr als 15°, bevorzugt von nicht mehr als 10° und am meisten bevorzugt von nicht mehr als 5° zur Flächennormalen des Substrats (4) auftreffen.

3. Verfahren nach einem der vorhergehenden Ansprüche, wobei in der Vakuumumgebung (1) ein Hintergrundgasdruck von höchstens 1 x 10⁻¹ Pascal, bevorzugt von höchstens 1 x 10⁻² Pascal und mehr bevorzugt von höchstens 1 x 10⁻³ Pascal vorliegt; und / oder wobei das Substrat (4) an einer Austrittsöffnung des Expansionsraums (3), vorzugsweise kontinuierlich, vorbeibewegt wird.

4. Verfahren nach einem der vorhergehenden Ansprüche, wobei
die Teilchen des gasförmigen metallischen Materials (9) beim Ausströmen aus einer Gasquelle (2) eine mittlere freie Weglänge von weniger als 1 mm, bevorzugt von weniger als 0,1 mm und mehr bevorzugt von weniger als 0,05 mm aufweisen; und / oder, wobei
der Dampfdruck des metallischen Materials (9) in der Gasquelle (2) zumindest 10¹ Pascal, bevorzugt zumindest 10² Pascal und mehr bevorzugt zumindest 10³ Pascal beträgt.

5. Vorrichtung zum Beschichten eines Substrats (4), insbesondere eines supraleitenden Bandleiters, in einer Vakuumumgebung (1), aufweisend:
a. eine Gasquelle (2) zum Erzeugen eines metallischen Materials (9) in der Gasphase;
b. wobei die Gasquelle (2) eine Öffnung aufweist, aus der das gasförmige; metallischen Materials (9) in einen Expansionsraum (3) strömt; und
c. wobei der Expansionsraum (3) dazu eingerichtet ist, das gasförmige metallische Material (9) expandieren zu lassen und auf das Substrat (4) zu richten.

6. Vorrichtung nach Anspruch 5, wobei der Expansionsraum (3) dazu eingerichtet ist, zumindest eine laterale Impulskomponente der Teilchen des gasförmigen metallischen Materials (9) in eine longitudinale Impulskomponente in Richtung des Substrats (4) umzuwandeln; und / oder wobei
der Expansionsraum (3) dazu eingerichtet ist, eine überschallschnelle Strömung des gasförmigen metallischen Materials (9) in Richtung des Substrats (4) zu erzeugen; und / oder wobei
der Expansionsraum (3) dazu eingerichtet ist, die Teilchen des gasförmigen metallischen Materials (9) so auf das Substrat (4) zu richten, dass sie unter einem Winkel von nicht mehr als 15°, bevorzugt von nicht mehr als 10° und am meisten bevorzugt von nicht mehr als 5° zur Flächennormalen des Substrats (4) auftreffen.

7. Vorrichtung nach einem der vorhergehenden Ansprüche 5-6, ferner umfassend eine den Expansionsraum (3) umgebende Mantelfläche, wobei
zumindest ein Teil der Mantelfläche eine Anti-Haftbeschichtung, vorzugsweise eine Perfluorpolyether, PFPE, -Antihaftbeschichtung aufweist; und / oder wobei
zumindest ein Teil der Mantelfläche derart behandelt ist, dass die Absorption von Wärmestrahlung erhöht ist; und / oder wobei
zumindest ein Teil der Mantelfläche aktiv gekühlt ist.

8. Vorrichtung nach einem der vorhergehenden Ansprüche, wobei
der Expansionsraum (3) eine dem Substrat (4) zugewandte Austrittsöffnung sowie eine der Gasquelle (2) hin zugewandte Eintrittsöffnung aufweist, wobei das Verhältnis der Durchmesser der Austrittsöffnung und der Eintrittsöffnung zumindest 1.5, bevorzugt zumindest 1.75 und mehr bevorzugt zumindest 2.0 beträgt; und / oder wobei
das Verhältnis aus dem Abstand zwischen der Eintrittsöffnung und dem Substrat und dem Abstand zwischen der Eintrittsöffnung und der Austrittsöffnung zumindest 1.0, und höchstens 1.4 beträgt, und / oder wobei
das Verhältnis aus dem Abstand zwischen der Austrittsöffnung und der Eintrittsöffnung und dem Durchmesser der Austrittsöffnung zumindest 1.5 beträgt.

9. Vorrichtung nach einem der vorhergehenden Ansprüche, wobei sich der Expansionsraum (3) von der Gasquelle (2) zum Substrat (4) hin verbreitert, insbesondere konisch oder glockenförmig verbreitert; und / oder wobei
der Expansionsraum (3) die Form eines divergenten Teils einer Lavaldüse aufweist; und / oder wobei
die Öffnung der Gasquelle (2) eine Öffnungsblende aufweist, die vorzugsweise zumindest eine Lamelle aufweist; und / oder wobei
die Gasquelle (2) und / oder die Öffnungsblende aus einem Material mit hohem Schmelzpunkt gefertigt ist, vorzugsweise aus Wolfram, Tantal, Molybdän, Kohlenstoff und /oder einer hitzebeständigen Keramik.

10. System zum Beschichten eines Substrats (4), insbesondere eines supraleitenden Bandleiters, in einer Vakuumumgebung (1) aufweisend;
a. zumindest eine Beschichtungszone (5), in der ein metallisches Material (9) auf dem Substrat (4) unter Verwendung der Vorrichtung nach einem der Ansprüche 5-9 abgeschieden wird, wobei das Substrat (4) die zumindest eine Beschichtungszone (5) zumindest zweimal durchläuft; oder
b. zumindest zwei Beschichtungszonen (5), in denen das metallisches Material (9) auf dem Substrat (4) unter Verwendung der Vorrichtung nach einem der Ansprüche 5-9 abgeschieden wird, wobei das Substrat (4) die zumindest zwei Beschichtungszonen (5) zumindest jeweils einmal durchläuft.

11. System nach dem vorhergehenden Anspruch 10, ferner umfassend
Mittel zum Ändern (6) der Orientierung des Substrats (4) nach einem ersten und vor einem zweiten Durchlauf durch die zumindest eine Beschichtungszone (5) oder vor dem Durchlauf durch die zweite Beschichtungszone (5).
Mittel zum Kühlen (8) des Substrats (4) nach einem ersten und vor einem zweiten Durchlauf durch die zumindest eine Beschichtungszone (5) oder vor dem Durchlauf durch die zweite Beschichtungszone (5); und / oder
zumindest einen in der oder um die zumindest eine Beschichtungszone (5) angeordneten Gasreflektor (7a, 7b), der Teilchen des metallischen Materials (9) in Richtung des Substrats (4) reflektiert.

12. System nach dem vorhergehenden Anspruch, wobei
zumindest ein Teil des zumindest einen Gasreflektors (7a, 7b) eine Anti-Haftbeschichtung aufweist; und / oder wobei
zumindest ein Teil des zumindest einen Gasreflektors (7a, 7b) derart behandelt ist, dass die Absorption von Wärmestrahlung erhöht ist; und / oder wobei
zumindest ein Teil des Gasreflektors (7a, 7b) aktiv gekühlt ist.

13. Beschichteter supraleitender Bandleiter (300), aufweisend:
a. zumindest eine supraleitende Schicht (310);
b. zumindest eine metallische Beschichtung (320), die auf dem Bandleiter (300) abgeschieden ist; und
c. wobei die Dicke der metallischen Beschichtung (320) zumindest 1 µm beträgt und über die Breite des beschichteten Bandleiters (300) nicht mehr als 10%, bevorzugt nicht mehr als 5% variiert.

14. Beschichteter supraleitender Bandleiter (300) nach dem vorhergehenden Anspruch, wobei die zumindest eine metallische Beschichtung (320) mit dem Verfahren nach einem der Ansprüche 1 - 4 und / oder der Vorrichtung nach einem der Ansprüche 5-9 und / oder dem System nach einem der Ansprüche 10 - 12 erzeugt worden ist.

15. Beschichteter supraleitender Bandleiter (300) nach einem der Ansprüche 13 oder 14, wobei das Volumen der zumindest einen metallischen Beschichtung (320) zu weniger als 5 %, bevorzugt zu weniger als 3% und mehr bevorzugt zu weniger als 1% aus Hohlräumen, Spalten und / oder Poren (440) besteht; und / oder wobei
die Flächendichte von in der metallischen Beschichtung eingelagerten oder auf der metallischen Beschichtung abgelagerten Metallpartikeln (450) mit einem durchschnittlichen Durchmesser von zumindest 10 µm, kleiner als 5/cm², bevorzugt kleiner als 3/cm², mehr bevorzugt kleiner als 1/cm² und am meisten bevorzugt kleiner als 0,1 / cm² ist; und / oder wobei
die zumindest eine metallische Beschichtung (320) Gold, Silber, Kupfer und / oder Zinn, deren Legierungen oder einer Abfolge dieser Metalle aufweist; und / oder wobei
die zumindest eine metallische Beschichtung (320) den Bandleiter (300) einhüllt.
